# EUROPEAN PATENT SPECIFICATION

(11) **EP 3 314 639 B1**
(45) Date of publication and mention of the grant of the patent: **24.07.2019**
(21) Application number: 16745889.2
(22) Date of filing: 24.06.2016
(51) Int. Cl.: H01L 21/67

(54) **PRESSURIZED HEATED ROLLING PRESS FOR MANUFACTURE OF PHOTOVOLTAIC CELLS**
ERHITZTE DRUCKROLLPRESSE ZUR HERSTELLUNG VON PHOTOVOLTAISCHEN ZELLEN
UNE PRESSE PRESSURISÉE ET CAUFFANTE DE FABRICATION DES CELLULES PHOTOVOLTAÏQUES

(30) Priority: 25.06.2015 US 201562184712 P; 23.06.2016 US 201615191375
(43) Date of publication of application: 02.05.2018
(60) Divisional application: 19176210.3
(73) Proprietor: Alta Devices, Inc., Sunnyvale, CA 94085 (US)
(72) Inventor: SORABJI, Khurshed, Sunnyvale, CA 94085 (US); YOSHIDA, Steven, Sunnyvale, CA 94085 (US); SANFORD, Eric, Sunnyvale, CA 94085 (US)
(74) Representative: Boult Wade Tennant LLP
(86) International application number: PCT/US2016/039411
(87) International publication number: WO 2016/210361

(56) References cited:
- US-A1- 2008 081 178
- US-A1- 2011 111 173

## Description

### FIELD OF THE INVENTION

The present invention relates generally to manufacturing techniques involving assemblies and more particularly to an improved method of manufacturing an assembly including higher-yielding cell feeders, a pressure-controlled thermal treatment process and apparatus, and an improved assembly process for a high throughput system.

### BACKGROUND OF THE INVENTION

Manufacturing processes which involve the assembly of components can be performed manually, automatically, or in combination, often in relation to the complexity of the manufacturing process. For instance, assembly processes that press a first component to a second component in a gluing operation often require compression resulting from force on the first component to the second component where an adhesive is affixed in advance in between. The steps involved in this basic assembly process can be simple or complex, in relation to the sensitivity, characteristics and nature of the components as well as the environment of the process itself. One method may involve a manual effort using a hand-guided light touch to press a first component onto the second to ensure that neither component is damaged based upon the experience of the operator manually performing the process. Another method may involve an automated robot device that is able to lift a first component from a tray and then align the first component over a second component having an adhesive coating, and press the first component onto the second component in relation to a control algorithm. Manual processes are often more difficult in environments that are caustic and high temperature, and often automated processes are difficult in processes that have delicate or sensitive components involved. Similarly, manual processes often are lower yield producing for higher-value components and automated processes having higher yields are often for lower-valued components. What is desired is an improvement to manufacturing processes that may produce higher yields of assembly where the assemblies include higher-valued and often sensitive components.

Often in the manufacturing of photovoltaic solar cells and photovoltaic solar cell components into photovoltaic devices such as solar mats, multiple laminate layers are applied to a carrier plate where both the contact and alignment are required to be precise and within particular pressure ranges as the components for example, solar cells are sensitive such that they may be easily broken or damaged during manufacture. As a result, often portions of assembly are manual with lower yields. Additionally, certain follow-on steps of the assembly process often involve high temperatures for curing the cell assemblies in which manual involvement may be dangerous or in some situations, impossible. As yields are sought to be improved, often more automated approaches are introduced which then create additional breakage or damage to the components during assembly, or in other situations, require additional steps to the existing processes which do not substantially reduce the processing times.

In US 011/111173 there is described a surface processing mask having a film mask and a method for manufacturing the same. In the film mask, particles are present as a single layer without overlapping with each other or particles containing first particles and second particles having etching resistance lower than that of the first particles are contained. Moreover, there is described a surface processing method including disposing the film mask on the front surface of a process target, and etching the front surface to form irregularities and an optical device having a substrate processed by the surface processing method. Moreover, there is also described a particle-containing film in which particles are arranged to form a single layer without overlapping with each other and a method for manufacturing the same.

In US 2008/081178 there is described a transparent conducting film containing transparent conducting fine particles and a manufacturing method of the transparent conducting film. The manufacturing method comprises forming a coating film by coating fluid material containing transparent conducting fine particles on a substrate; and sintering the transparent conducting fine particles by irradiating an electromagnetic wave after pressure is added to the coating film.

In US 2013/206213 there is described a photovoltaic module. The photovoltaic module comprises an array of shingled tiles disposed between a transparent front substrate and a back substrate, wherein the array of shingled tiles comprises a plurality of photovoltaic tiles in electrical contact with each other and positioned in overlapping rows. Each photovoltaic tile comprises a front metallic contact layer disposed on an epitaxial film stack disposed on a back metallic contact layer disposed on a support carrier layer. The photovoltaic module includes at least one bus bar in electrical contact with the array of shingled tiles and disposed between the front and back glass substrates. The photovoltaic module also includes an encapsulation layer between the front and back glass substrates.

Nonetheless, with demand for photovoltaic cells increasing and the utility of the cells being incorporated into more commercial opportunities in varied markets worldwide, there is a need for improvements to the standard manufacturing assembly processes, in the photovoltaic cell area as well as other assembly areas, to improve the yield without increasing damage to sensitive components, to reduce the risks to those involved in the manual processes while incorporating an approach having a lighter-touch" in the assembly process, and to reduce the time to process steps in the assembly, safely.

### SUMMARY OF THE INVENTION

According to the present invention there is provided a flexible component feeder source having the features of claim 1.

The flexible component feeder source comprises a flexible base suitable for protecting and receiving one or more photovoltaic cells for processing. The feeder source includes a base having a linear shape when opened and forms a roll when rolled.

A method and system for connecting a plurality of materials using pressure and curing is also described.

In one arrangement, a system for connecting a plurality of materials using pressure and curing comprises a flexible component feeder source for the providing plurality of materials at first location; a vacuum conveyor for receiving the plurality of materials at the first location wherein the vacuum conveyor includes a plurality of openings for a predetermined vacuum to hold the plurality of materials in place on the vacuum conveyor; a moving belt is adaptively positioned above the vacuum conveyor at a second location and the vacuum conveyor and the moving belt are arranged to be driven in a predetermined relation to one another for conveying the received plurality of materials from the first location to a second location along the vacuum conveyor; a vacuum pressure source for applying a predetermined vacuum pressure from at least one of the plurality of openings towards the moving belt and the vacuum conveyor as the plurality of materials are conveyed from the second location to a third location, creating a force compressing the plurality of materials; and a curing source at a second location for curing the compressed plurality of materials.

There is also described a method for connecting a plurality of materials using pressure and curing which comprises receiving the plurality of materials on the vacuum conveyor at a first location wherein the vacuum conveyor includes a plurality of openings for a predetermined vacuum pressure to hold the plurality of materials in place on the vacuum conveyor; conveying the received plurality of materials from the first location to a second location along the vacuum conveyor, where a moving belt is adaptively positioned above the vacuum conveyor at the second location and the vacuum conveyor and the moving belt are arranged to be driven in a predetermined relation to one another; and applying a predetermined vacuum pressure from at least one of the plurality of openings towards the moving belt and the vacuum conveyor as the plurality of materials are conveyed from the second location to a third location, creating a force compressing the plurality of materials; and curing the compressed plurality of materials.

### BRIEF DESCRIPTION OF THE SEVERAL VIEWS OF THE DRAWINGS

The drawings referenced herein form a part of the specification. Features shown in the drawing are meant as illustrative of only some examples of the invention, and not of all embodiments of the invention, unless otherwise explicitly indicated, and implications to the contrary are otherwise not to be made.
FIG. 1 diagrams illustratively an approach for processing photovoltaic cells.
FIGs. 2A and 2B diagram a flexible tape feeder having a plurality of photovoltaic cells in accordance with one or more embodiments of the present invention.
FIGs. 2C and 2D depict two methods for holding the photovoltaic cells in the tape feeder.
FIG. 3 diagrams a method of processing photovoltaic cells.
FIG. 4 diagrams a vacuum conveyor and a moving belt in relation arrangement.
FIG. 5 diagrams a vacuum conveyor and a moving belt in relational arrangement when under pressure from a vacuum source such as a vacuum pump creating a downward pressure.

### DETAILED DESCRIPTION

In the following detailed description of examples of the invention, reference is made to the accompanying drawings that form a part hereof, and in which is shown by way of illustration specific examples in which the invention may be practiced.

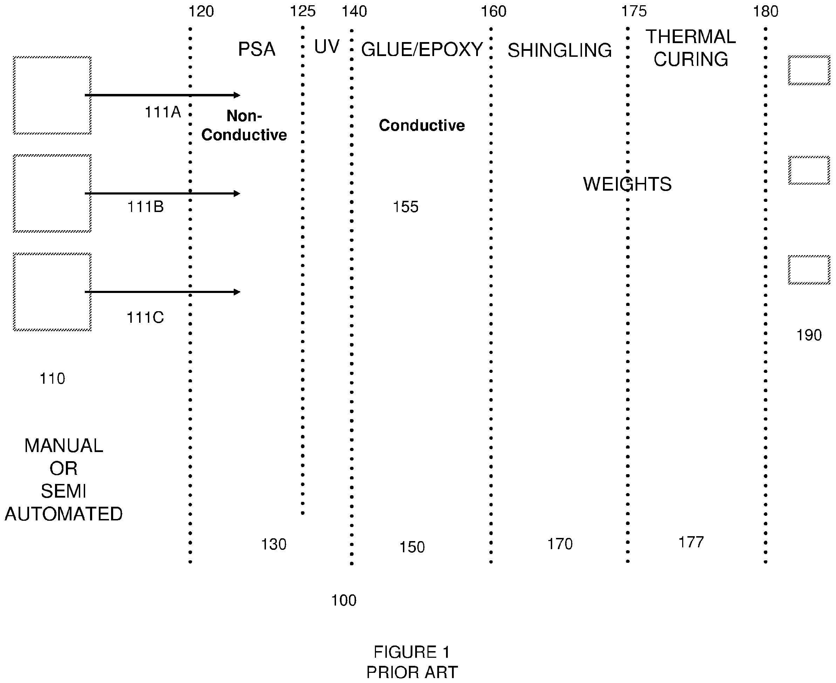

FIG. 1 diagrams illustratively an approach 100 for processing photovoltaic cells. From FIG. 1, a series of stacked cells 110 is located at the source of the approach 100 where each cell component is stacked in position to be processed in accordance with one of three processing lanes, 111A, 111B and 111C. Typically, the stacked cell components may be manually removed from the stacking and placed on a moving conveyor for processing. The stacked cells are often referred to as a 'coin stack' due to their physical arrangement. Human intervention is often necessitated due to the possibility of damage to the cells and the difficulty of the alignment of sensitive components by automated devices. Human intervention is also often necessitated as the cells are typically sticky or may have other material surface issues that require additional care in separating out the individual cells from one another in the coin stack. In certain situations, some automated equipment may be used in a limited manner though it should be realized that this process is typically a low speed process resulting in less than 10 parts per hour.

Once the components are aligned, the process proceeds to 120. At 120, the cells are prepared for a pressure sensitive adhesion (PSA) step. The PSA step 130 may involve application of a pressure sensitive adhesive which when the component is placed into contact with another component or material, creates a bond wherein each of the two parts are securely affixed to one another. Once the PSA step is completed, the cells move to 125 for UV curing which may comprise curing using ultra-violet (UV) light (i.e., UV-cure tunnel)

At 140, the cells then move to a gluing step at 150. In some situations, one side of a cell may have adhesive applied to it, in other situations, adhesive may be applied to one or more component parts. Glue may be applied by hand or by equipment though the latter is often difficult. Once a gluing step is completed, the cells move to a shingling step 160.

At shingling step 160, the cells are coupled together through preferably a shingling process 170. The shingling process involves connecting the photovoltaic cells together. Examples of this process are described in US Patent Publication No. 2013/0206213.

It is typical to place weights or apply other physical devices, such as rollers, to at least one of the component portions in order to create a secure bond between the two components. Using weights at 175, while typical, creates additional risks as the use of weights may cause sensitive components to be damaged or require further hardware replacement during operations which may be difficult or expensive. Alternatively, it is also known to use clamps to achieve a similar effect.

At 175, the cells are prepared for the curing step. The curing step 177 may involve ovens, and other thermal or light-based processes. Once the curing step is completed, the cell then moves to 180. At 180, the processing is completed for the affected photovoltaic cell and the completed photovoltaic cell results at 190.

As used herein, the term 'components' and 'materials' may include Gallium Arsenide (GaAs) based components or other photovoltaic components such as photovoltaic cells for example, flexible, thin-film photovoltaic devices comprising semiconductor material, which may or may not be single-crystal, including but not limited to Group III-V materials such as GaAs, AIGaAs, InGaAs, AlInGaAs, InGaAsP, InGaP, AlInGaP, and AllnP (and combinations thereof); Group IV materials such as Si, amorphous Si, Ge, SiGe; Group II-VI materials such as CdTe; other materials such as CIGS (Copper indium gallium (di)selenide), perovskites such as lead halides, organic semiconductors, CZTS, CZTSSe, and dye-sensitized photovoltaic absorber materials, and will typically be layered arrangements of materials which have one or more interface layers that promote a fixed arrangement as between the material layers following a processing sequence.

Examples of such materials, without limitation, may include photovoltaic cells, solar cells, solar panels, layered plastic components, electronic components, high density interconnects, chips, chips on flex, mixed composition materials having multiple layers arranged to be securely arranged with one another, and combinations thereof, for instance.

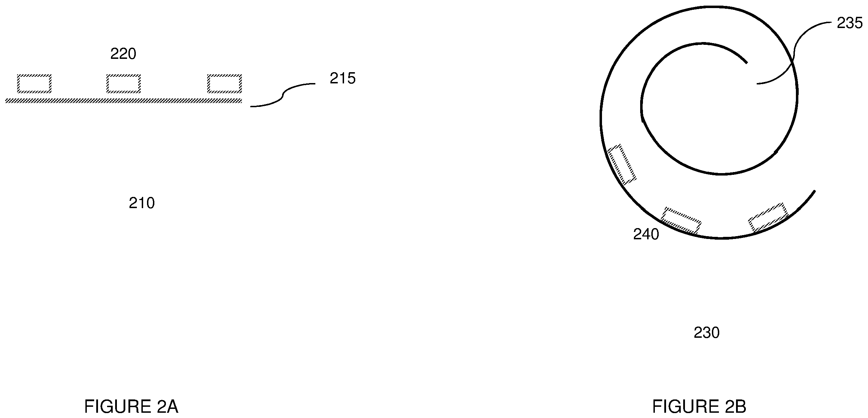

FIGs. 2A and 2B diagram a flexible tape feeder 210 having a plurality of photovoltaic cells 220 in connectable arrangement with the tape base 215, in accordance with one or more embodiments of the present invention. The tape feeder, or tape carrier, provides a source of components to be fed into the assembly or process. The flexible tape feeder also provides a flexible backing to flexible cells to be assembled thereby reducing damage to the cells during the feeding process. The use of the tape feeder is preferred over the coin stacking method as the tape feeder provides a reuse aspect, is more protective of the sensitive components arranged thereon, and is more efficient in the assembly operation. In an embodiment, the flexible tape feeder may comprise any of polyethylene terephthalate (PET), porous materials including paper, cloth and a combination thereof.

Traditional operations use a coin stacking approach which requires a larger footprint in the assembly process and also does not protectably secure the sensitive devices to be processed. The tape feeder provides a linear flexible base 315 in which sensitive components 220 may be situated, protectively, for processing in the assembly process. The flexible base is of a linear shape when opened and forms a roll when rolled. Alternatively, the flexible base is of linear shape when under taught tension and retracts to a coil shape when tension to the base is absent.

In an embodiment, the linear base of the tape feeder at 230 may be arranged to provide for a coiling capability 235 where once a tape is populated with a plurality of sensitive components 240, the tape may be wound into the shape of a coil or roll. The coiled tape may then be placed at the beginning of the assembly process whereafter humans and/or robots may readily access the sensitive components situated thereon, removing them for processing. As the tape is fed for the process, the coiled arrangement requires less space and the tape may be rolled into a reusable stock tape during the process as each component is removed.

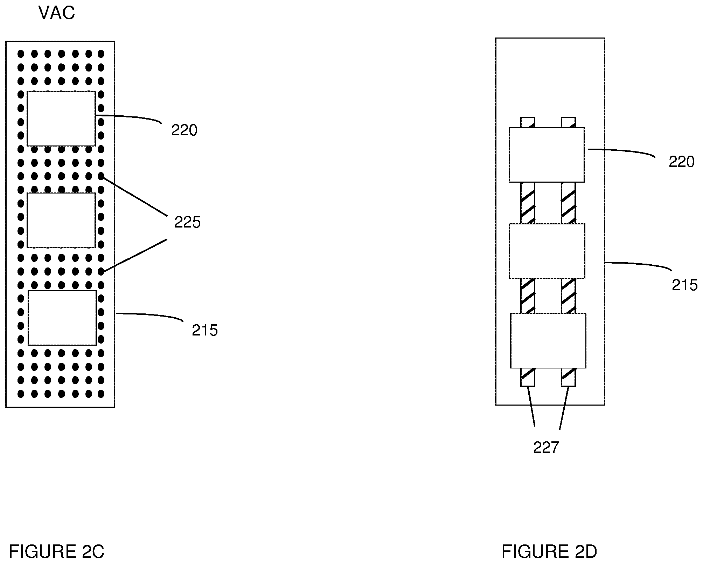

In an embodiment, a width of the flexible base is approximately similar to a size of the photovoltaic cells. In one or more preferred arrangements, instead of a few active lines of processing from traditional stacked cell arrangements involving trays, coin stacking and the like, the present arrangement provides for a six lane processing arrangement using only three tape rolls of components in which a single tape roll can be used to feed a plurality of active processing lanes. In this manner, the use of the tape feeder of the present invention also promotes a higher speed operation over the traditional approach. The photovoltaic cells can be carried by the tape feeder in a variety of ways. FIGs. 2C and 2D depicts two methods for holding the photovoltaic cells in the tape feeder. In a first embodiment shown in Figure 2C a vacuum is applied through the openings 225 in the linear base 215 to hold the photovoltaic cells 220 in place.

In a second embodiment shown in Figure 2D adhesive strips 227 on the linear base 215 are utilized to hold the photovoltaic cells 320 in place. One of ordinary skill in the art readily recognizes that either of or both of the methods together can be utilized to hold the photovoltaic cells 220 in place. For example, in one embodiment, the linear base can use a combination of strategically placed openings 225 and strategically placed adhesive strips 227 and that would be within the scope of the present invention. In an alternate embodiment, various other materials such as but not limited to adhesive pads, adhesive tape, glue, PSA, a mechanism to hold the photovoltaic cells in place or a combination of such materials/mechanisms can be used to hold the photovoltaic cells in place.

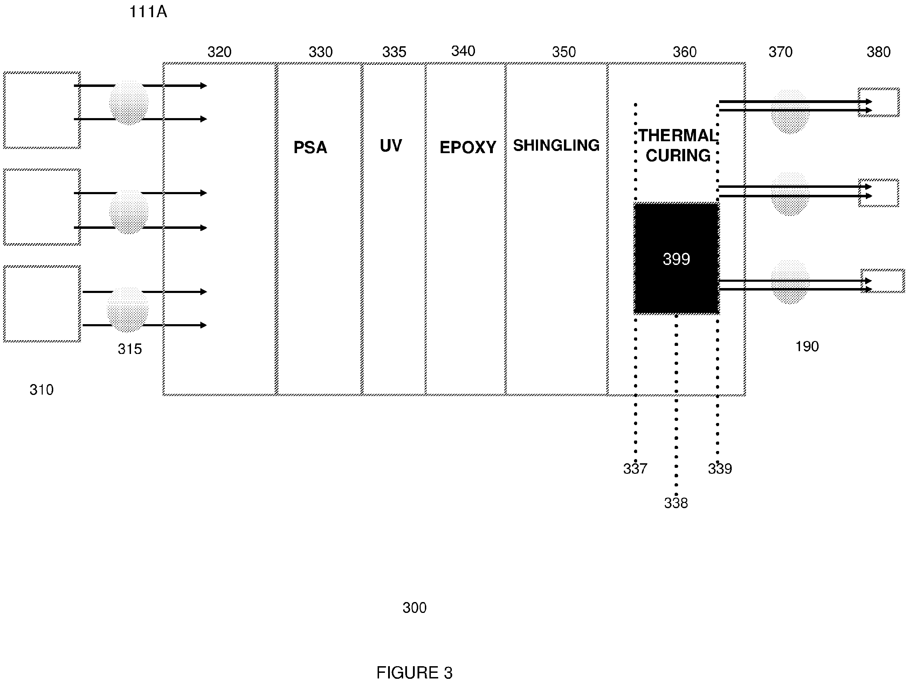

FIG. 3 diagrams a method 300 of processing photovoltaic cells. A tape feeder, described above, is situated at the beginning of a preferred assembly method at 310 as shown in FIG. 3. Preferably, automated equipment 315 removes the sensitive components (or materials) situated on the tape feeder and places them in a predetermined arrangement on the conveyor for processing at 320 corresponding to element 111A shown in Figure 1. In one or more preferred arrangements, the automated equipment may stack two components that are to be securely arranged together atop one another, next to one another, or proximate to one another. The components are then prepped for the next phase of processing, which for the exemplary purposes of FIG. 3 is a phase of receiving a PSA treatment at 330. At 330, the components are prepared and are arranged in layered form with an adhesive based interface between the arranged components as a layered component. The PSA step 330 may involve application of a pressure sensitive adhesive which when the component is placed into contact with another component or material, creates a bond wherein each of the two parts are securely affixed to one another. Once the PSA step is completed, the cells then move to 335 for UV curing which may comprise curing using ultra-violet (UV) light (i.e., UV-cure tunnel).

At 340, conductive epoxy, for example, is placed on one or more sides of at least one component to be processed and the components are arranged before the next step of shingling the components.

Thereafter the prepared photovoltaic cells are coupled together via shingling process 350. In one or more arrangements, the next phase is a curing step in which an oven, conventional oven, convection oven, lamp-based source, or thermal source is used, though other possibilities are envisioned. Curing could also be done by other methods, including but not limited to UV exposure, or evaporation of the solvent in air or in a vacuum, for example.

The layered component is then conveyed along a conveyor for thermal curing without the use of physical pressure plates or devices. At 360, the layered component will traverse from a first location 337 to a second location 338 where at the second location the upper portion of the layered component will be under pressure from a surface of a moving belt in adaptable contact with the upper portion.

At the first location 337, the layered component is situated on the conveyor which in one or more preferred arrangements is a vacuum conveyor having a plurality of openings therein. Preferably the vacuum conveyor is also comprised of a durable material that provides rigidity and flexibility under pressure, such as being at least partly comprised of metal (SST, Al, etc.), high temp plastic, ceramic, granite, etc.. As the layered material traverses from the first location to the second location, in one arrangement, a moving belt is situated above the conveyor and above the layered component. The moving belt can be an idler belt or a driven belt situated above the conveyor and above the layered component. In one arrangement, the moving belt is not in contact with the layered component at the first location 337 but is in contact with the layered component at approximately the second location 338 and for a period of travel proximate thereto depending on the physical arrangement in one or more preferred arrangements. A pressure source, such as an air pump, vacuum pump, or pressurized air flow is positioned proximate to the idler belt or the driven belt and is adaptable and adjustable to control the flow of air from the air source to and across the idler belt or the driven belt and the vacuum conveyor, at 360. In one or more arrangements, a vacuum pump is controlled by a controller in which there are multiple zones of varying pressure between the second location 338 and the third location 339, for example.

At approximately the second location 338, in one or more preferred arrangements, the idler belt is in contact with the upper portion of the layered material. In operation, when no air pressure provided from the air source, the idler belt will be in 'non-pressured' contact with the upper surface of the layered material, resulting in the idler belt rolling at the same speed to that of the layered component due to the friction created. However, in operation, when there is active air pressure provided from the air source, the idler belt will be in 'pressured' contact with the upper surface of the layered material, resulting in the idler belt applying a pressure force to the upper portion of the layered material thereby forcibly pressuring the upper portion onto the lower portion. The rolling speed of the idler belt will act resistively towards the layered material though the speed may approximate a speed similar to that of the layered component due to the friction created. The idler belt will remain in non-pressured or pressured contact with the upper portion of the layered component until the layered component reaches a third location at 339. The user is able to adaptably adjust the amount of pressure a layered component receives based on the air source, the length of contact with the idler belt, and the environmental conditions of the process.

In one arrangement, the movement of the moving belt is controlled in relation to the time and pressure required for cure. Similarly, speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time required for curing. In one arrangement, the moving belt can be an idler belt or a driven belt situated above the conveyor and above the layered component.

At the third location 339, the layered materials have been situated together based on the pressured or non-pressured contact. Depending on the layered materials of the process, the curing time of phase 360 may differ substantially and may also depend on the user's interest in achieving a full or partial cure for the layered material. For instance, where the layered materials are photovoltaic cells, the method provides that approximately one minute per cell matrix would be a reasonable estimate of the curing time required, with a slightly longer time being required if a plurality of matrices is placed in parallel for instance, by example.

After the curing phase at 360, the finished layered components are cooled from the phase of curing, via active or passive cooling and are removed preferably by automated equipment at 370 corresponding to element 190 shown in Figure 1. For clarity, while use of automated equipment is discussed and preferred in certain applications, it is not required as the described method is also capable of being operated without automated equipment and in an arrangement that is partly automated equipment and partly human interaction, without limitation.

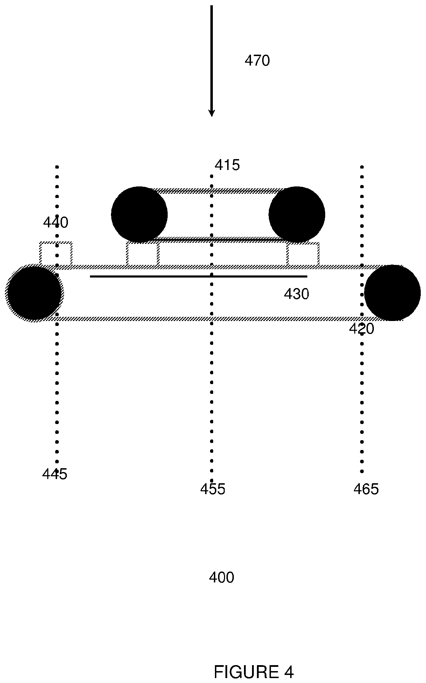

FIG. 4 diagrams a vacuum conveyor 420 and a moving belt 415 in relational arrangement at 400. The moving belt can be an idler belt or a driven belt situated above the conveyor and above the layered component. As shown in FIG. 4, a multi-layer component is entering the drive arrangement 400 at 440 at a first location 445. The multi-layer component is situated on the conveyor (i.e., vacuum conveyor) 420 and is conveyed to a second point 455. At the second location 455, the moving belt 415, for example, an idler belt may be situated to be in non-pressurized or pressurized contact with the upper portion of the multi-layered component. After possible contact at the second location 455, the multi-layer component is continued to be conveyed along the vacuum conveyor to a third location 465.

As shown in FIG. 4 the vacuum conveyor 420 and the idler belt 415 may be driven by the same motor drive or controller; in another arrangement, the vacuum conveyor 420 and the idler belt 415 are driven independently. In a preferred arrangement the vacuum conveyor 420 is fabricated from steel. In a further preferred arrangement, a pressure plate is present at 430 which provides additional support to layered components on the surface of the vacuum conveyor 420 during a pressurized air flow.

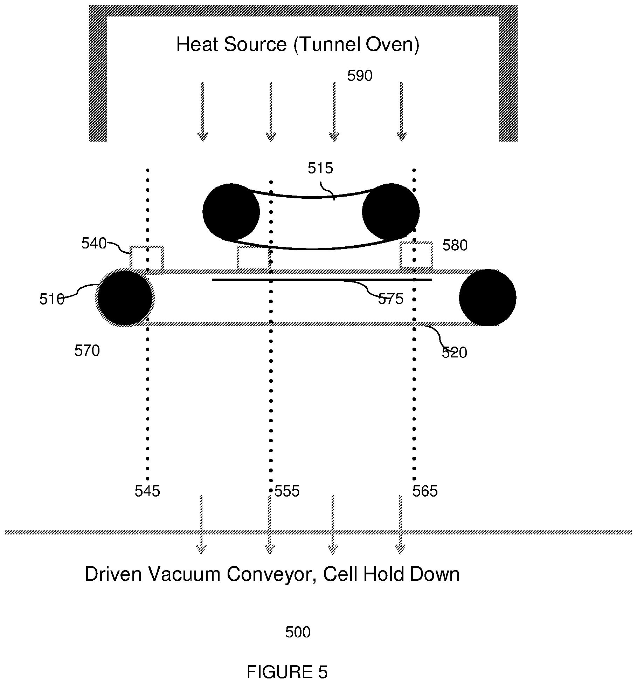

FIG. 5 diagrams a vacuum conveyor 520 and a moving belt 515 in relational arrangement at 500 when under pressure from a vacuum source such as a vacuum pump creating a downward pressure. The moving belt can be an idler belt or a driven belt situated above the conveyor and above the layered component. As shown in FIG. 5, a multi-layer component 540 is entering the drive arrangement 510 at a first location 545. The multi-layer component 540 is situated on the conveyor system (i.e. vacuum conveyor) 520 and is conveyed to a second location at 555. At the second location, the idler belt 515, in the example, is under pressure from a vacuum pump creating a pressurized force downwards such that the upper portion of the multi-layered component 540 is in contact with the idler belt 515. As the multi-layered component 540 is conveyed from the second location 555, the idler belt 515 applies pressure to the upper portion and the upper portion is compressed onto the lower portion which continues to ride along the vacuum conveyor 520 above a reinforcing plate preferably situated at 575, between the second location 555 and the third location 565. The force of the pressure may be adjusted by varying the vacuum pump, etc.. After contact at the second location
555 and thereafter, the multi-layer component 540 is continued to be conveyed along the vacuum conveyor to the third location 565 where the contact to the upper portion from the idler belt 515 ceases and the compressed multi-layered component 540 is at a final stage at 580.

In one example, the top of the arrangement 500 is heated by a tunnel oven 590 while the bottom of the arrangement 500 may either be heated, unheated or actively cooled as required by the process. In such an example, temperature may be used to also facilitate the pressure adhesion process.

In operation, when there is no air pressure provided from the air source (or vacuum source), the idler belt will be in 'non-pressured' contact with the upper surface of the layered material, resulting in the idler belt rolling at a speed approximately similar to that of the layered component due to the friction created. In another arrangement, the idler belt is in adjustable contact with the upper portion based upon physical arrangement and air source pressure such that there is no contact with the upper portion absent an air source.

In one arrangement, the movement of the moving belt is controlled in relation to the time and pressure required for cure. Similarly, speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time
required for curing. In one arrangement, the moving belt can be an idler belt or a driven belt situated above the conveyor and above the layered component.

As is apparent from the above description, the described method is able to achieve significant benefits in the area without the use of weights, clamps and rollers, or other physical devices which add additional wear and create potential damage to sensitive components being processed. Further the process is able to recognize improved throughput and speed in processing and further facilitates the deployment of automated equipment into environments that may be dangerous for human intervention.

## Claims

1. A flexible component feeder source (210, 230) comprising:
a flexible base (215) suitable for protecting and receiving one or more photovoltaic cells (220), **characterized in that** the flexible component feeder source (210, 230) is configured to feed the one or more photovoltaic cells (220) to a plurality of active processing lanes (111A, 111B, 111C) in an assembly operation (100) for processing the one or more photovoltaic cells (220), **in that** the one or more photovoltaic cells (220) is configured to be removably affixed to the flexible base (215) and the flexible base (215) is of a linear shape when opened and forms a coil shape (235) when rolled, and **in that** the flexible base (215) is configured to be placed at the beginning of the plurality of active processing lanes (111A, 111B, 111C) in the coil shape (235) for the flexible component feeder source (210, 230) to feed the one or more photovoltaic cells (220) to the assembly operation (100) by having each of the one or more photovoltaic cells (220) removed from the flexible base (215) for processing.

2. The flexible component feeder source (210, 230) of claim 1, wherein the flexible base (215) is configured to be of the linear shape when under taught tension and to retract to the coil shape (235) when tension to the flexible base (215) is absent.

3. The flexible component feeder source (210, 230) of claim 1, wherein the one or more photovoltaic cells (220) is configured to be removably affixed to one side of the flexible base (215).

4. The flexible component feeder source (210, 230) of claim 1, wherein the one or more photovoltaic cells (220) is configured to be removably affixed to the flexible base (215) using any of adhesive pads, adhesive tape, glue, PSA, a mechanism to hold the photovoltaic cells (220) in place or a combination thereof.

5. The flexible component feeder source (210, 230) of claim 1, wherein the flexible base (215) has a plurality of openings (225) and the one or more photovoltaic cells (220) is configured to be removably affixed to the flexible base (215) using a vacuum applied through the plurality of openings (225).

6. The flexible component feeder source (210, 230) of claim 1, wherein the one or more photovoltaic cells (220) is configured to be removably affixed to the flexible base (215) such that the one or more photovoltaic cells (220) are removable by an automated device.

7. The flexible component feeder source (210, 230) of claim 1, wherein the one or more photovoltaic cells (220) is configured to be removably affixed to the flexible base (215) such that the one or more photovoltaic cells (220) are removable by manual removal.

8. The flexible component feeder source (210, 230) of claim 1, wherein each photovoltaic cell (220) of the one or more photovoltaic cells (220) is configured to be removably affixed to the flexible base (215) in a protective manner to avoid damage and contact with one another when the flexible base (215) is in the coil shape (235).

9. The flexible component feeder source (210, 230) of claim 1, wherein the flexible base (215) is reusable.

10. The flexible component feeder source (210, 230) of claim 1, wherein a width of the flexible base (215) is similar to a size of the one or more photovoltaic cells (220).

11. The flexible component feeder source (210, 230) of claim 1, wherein a width of the flexible base (215) is configured to be varied to feed more than one of the plurality of active processing lanes (111A, 111B, 111C) with the one or more photovoltaic cells (220).

12. The flexible component feeder source (210, 230) of claim 1, wherein the flexible base (215) further comprises any of polyethylene terephthalate (PET), paper and cloth.

## Patentansprüche

1. Flexible Komponentenzuführungsquelle (210, 230) mit
einer zum Schutz und zur Aufnahme einer oder mehrerer Photovoltaikzellen (220) geeigneten flexiblen Basis (215), **dadurch gekennzeichnet, dass**
die flexible Komponentenzuführungsquelle (210, 230) konfiguriert ist, um die eine oder die mehreren Photovoltaikzellen (220) einer Mehrzahl von aktiven Verarbeitungsstrecken (111A, 111B, 111C) in einem Montagevorgang (100) zum Bearbeiten der einen oder mehreren Photovoltaikzellen (220) zuzuführen,
dass die eine oder die mehreren Photovoltaikzellen (220) konfiguriert sind, um lösbar an der flexiblen Basis (215) befestigt zu werden, und die flexible Basis (215) im geöffneten Zustand linear ausgebildet ist und beim Rollen eine Spulenform (235) bildet, und
dass die flexible Basis (215) konfiguriert ist, um in der Spulenform (235) am Anfang der Mehrzahl von aktiven Verarbeitungsstrecken (111A, 111B, 111C) angeordnet zu werden, so dass die flexible Komponentenzuführungsquelle (210, 230) die eine oder mehreren Photovoltaikzellen (220) dem Montagevorgang (100) zuführt, indem jede der einen oder mehreren Photovoltaikzellen (220) zur Verarbeitung von der flexiblen Basis (215) entfernt wird.

2. Flexible Komponentenzuführungsquelle (210, 230) nach Anspruch 1, bei der die flexible Basis (215) konfiguriert ist, um unter aufgebrachter Spannung linear zu sein und sich in die Spulenform (235) zurückzuziehen, wenn keine Spannung auf die flexible Basis (215) einwirkt.

3. Flexible Komponentenzuführungsquelle (210, 230) nach Anspruch 1, bei der die eine oder die mehreren Photovoltaikzellen (220) konfiguriert sind, um lösbar an einer Seite der flexiblen Basis (215) befestigt zu sein.

4. Flexible Komponentenzuführungsquelle (210, 230) nach Anspruch 1, bei der die eine oder die mehreren Photovoltaikzellen (220) konfiguriert sind, um unter Verwendung von Klebepads, Klebeband, Klebstoff, PSA, einem Mechanismus zum Halten der Photovoltaikzellen (220) oder einer Kombination derselben lösbar an ihrem Platz an der flexiblen Basis (215) befestigt zu sein.

5. Flexible Komponentenzuführungsquelle (210, 230) nach Anspruch 1, bei der die flexible Basis (215) eine Mehrzahl von Öffnungen (225) aufweist und die eine oder die mehreren Photovoltaikzellen (220) konfiguriert ist, um unter Verwendung eines durch die Mehrzahl von Öffnungen (225) angelegten Vakuums lösbar an der flexiblen Basis (215) befestigt zu werden.

6. Flexible Komponentenzuführungsquelle (210, 230) nach Anspruch 1, bei der die eine oder die mehreren Photovoltaikzellen (220) konfiguriert sind, um lösbar an der flexiblen Basis (215) befestigt zu werden, so dass die eine oder mehreren Photovoltaikzellen (220) durch eine automatisierte Vorrichtung entfernbar sind.

7. Flexible Komponentenzuführungsquelle (210, 230) nach Anspruch 1, wobei die eine oder die mehreren Photovoltaikzellen (220) konfiguriert sind, um lösbar an der flexiblen Basis (215) befestigt zu werden, so dass die eine oder mehreren Photovoltaikzellen (220) durch manuelle Entfernung entfernbar sind.

8. Flexible Komponentenzuführungsquelle (210, 230) nach Anspruch 1, bei der jede Photovoltaikzelle (220) der einen oder mehreren Photovoltaikzellen (220) konfiguriert ist, um lösbar an der flexiblen Basis (215) schützend befestigt zu werden, um Beschädigungen und Kontakt miteinander zu vermeiden, wenn die flexible Basis (215) in der Spulenform (235) vorliegt.

9. Flexible Komponentenzuführungsquelle (210, 230) nach Anspruch 1, bei der die flexible Basis (215) wiederverwendbar ist.

10. Flexible Komponentenzuführungsquelle (210, 230) nach Anspruch 1, bei der eine Breite der flexiblen Basis (215) ähnlich einer Größe der einen oder mehreren Photovoltaikzellen (220) ist.

11. Flexible Komponentenzuführungsquelle (210, 230) nach Anspruch 1, bei der eine Breite der flexiblen Basis (215) so konfiguriert ist, dass sie variiert werden kann, um mehr als eine der mehreren aktiven Verarbeitungsstrecken (111A, 111B, 111C) mit der einen oder den mehreren Photovoltaikzellen (220) zu versorgen.

12. Flexible Komponentenzuführungsquelle (210, 230) nach Anspruch 1, bei der die flexible Basis (215) ferner Polyethylenterephthalat (PET), Papier und/oder Gewebe umfasst.

## Revendications

1. Source d'alimentation en composant flexible (210, 230) comprenant :
une base flexible (215) appropriée pour protéger et recevoir une ou plusieurs cellule(s) photovoltaïque(s) (220),
**caractérisée en ce que**
la source d'alimentation en composant flexible (210, 230) est configurée pour fournir la ou les plusieurs cellule(s) photovoltaïque(s) (220) à une pluralité de voies de traitement actives (111A, 111B, 111C) lors d'une opération d'assemblage (100) pour traiter la ou les plusieurs cellule(s) photovoltaïque(s) (220),
**en ce que** la ou les plusieurs cellule(s) photovoltaïque(s) (220) est/sont configurée(s) pour être fixée(s) de manière amovible à la base flexible (215) et la base flexible (215) a une forme linéaire lorsqu'elle est ouverte et présente une forme de bobine (235) lorsqu'elle est enroulée, et
**en ce que**
la base flexible (215) est configurée pour être placée au début de la pluralité de voies de traitement actives (111A, 111B, 111C) dans la forme de bobine (235) pour que la source d'alimentation en composant flexible (210, 230) fournisse la ou les plusieurs cellule(s) photovoltaïque(s) (220) à l'opération d'assemblage (100) en ayant chacune de la ou des plusieurs cellule(s) photovoltaïque(s) (220) retirée de la base flexible (215) pour le traitement.

2. Source d'alimentation en composant flexible (210, 230) de la revendication 1, dans laquelle la base flexible (215) est configurée pour être de forme linéaire lorsqu'elle est soumise à une tension enseignée et pour se rétracter vers la forme de bobine (235) lorsque la tension sur la base flexible (215) est absente.

3. Source d'alimentation en composant flexible (210, 230) de la revendication 1, dans laquelle la ou les plusieurs cellule(s) photovoltaïque(s) (220) est/sont configurée(s) pour être fixée(s) de manière amovible à un côté de la base flexible (215).

4. Source d'alimentation en composant flexible (210, 230) de la revendication 1, dans laquelle la ou les plusieurs cellule(s) photovoltaïque(s) (220) est/sont configurée(s) pour être fixée(s) de manière amovible à la base flexible (215) en utilisant un élément parmi des tampons adhésifs, un ruban adhésif, de la colle, PSA, un mécanisme pour maintenir les cellules photovoltaïques (220) en place ou une combinaison de ceux-ci.

5. Source d'alimentation en composant flexible (210, 230) de la revendication 1, dans laquelle la base flexible (215) a une pluralité d'ouvertures (225) et la ou les plusieurs cellule(s) photovoltaïque(s) (220) est/sont configurée(s) pour être fixée(s) de manière amovible à la base flexible (215) en utilisant un vide appliqué à travers la pluralité d'ouvertures (225).

6. Source d'alimentation en composant flexible (210, 230) de la revendication 1, dans laquelle la ou les plusieurs cellule(s) photovoltaïque(s) (220) est/sont configurée(s) pour être fixée(s) de manière amovible à la base flexible (215) de sorte que la ou les plusieurs cellule(s) photovoltaïque(s) (220) puisse/puissent être retirée(s) par un dispositif automatisé.

7. Source d'alimentation en composant flexible (210, 230) de la revendication 1, dans laquelle la ou les plusieurs cellule(s) photovoltaïque(s) (220) est/sont configurée(s) pour être fixée(s) de manière amovible à la base flexible (215) de sorte que la ou les plusieurs cellule(s) photovoltaïque(s) (220) puisse/puissent être retirée(s) par retrait manuel.

8. Source d'alimentation en composant flexible (210, 230) de la revendication 1, dans laquelle chaque cellule photovoltaïque (220) de la ou des plusieurs cellule(s) photovoltaïque(s) (220) est configurée pour être fixée de manière amovible à la base flexible (215) de manière protectrice afin d'éviter les dommages et le contact les unes avec les autres lorsque la base flexible (215) a la forme de bobine (235).

9. Source d'alimentation en composant flexible (210, 230) de la revendication 1, dans laquelle la base flexible (215) est réutilisable.

10. Source d'alimentation en composant flexible (210, 230) de la revendication 1, dans laquelle une largeur de la base flexible (215) est similaire à une taille de la ou des plusieurs cellule(s) photovoltaïque(s) (220).

11. Source d'alimentation en composant flexible (210, 230) de la revendication 1, dans laquelle une largeur de la base flexible (215) est configurée de manière à varier pour fournir, à plus d'une de la pluralité de voies de traitement actives (111A, 111B, 111C), la ou les plusieurs cellule(s) photovoltaïque(s) (220).

12. Source d'alimentation en composant flexible (210, 230) de la revendication 1, dans laquelle la base flexible (215) comprend en outre l'un du polyéthylène téréphtalate (PET), du papier et d'un tissu.
